Europäisches Patentamt

European Patent Office

Office européen des brevets

(19)

(11) EP 0 625 823 B1

(12) FASCICULE DE BREVET EUROPEEN

(45) Date de publication et mention
de la délivrance du brevet:
**11.08.1999 Bulletin 1999/32**

(51) Int Cl.6: **H03F 3/60**

(21) Numéro de dépôt: **94201363.2**

(22) Date de dépôt: **13.05.1994**

(54) **Dispositif semiconducteur hyperfréquences comprenant des moyens de stabilisation**

Hyperfrequenz-Halbleiteranordnung mit Stabilisierungsmitteln

Hyperfrequency semiconductor device with stabilizing means

(84) Etats contractants désignés:
**DE FR GB**

(30) Priorité: **18.05.1993 FR 9305997**

(43) Date de publication de la demande:
**23.11.1994 Bulletin 1994/47**

(73) Titulaires:
* **LABORATOIRES D'ELECTRONIQUE PHILIPS S.A.S.**
  **94450 Limeil-Brévannes (FR)**
  Etats contractants désignés:
  **FR**
* **Koninklijke Philips Electronics N.V.**
  **5621 BA Eindhoven (NL)**
  Etats contractants désignés:
  **DE GB**

(72) Inventeurs:
* **Gamand, Patrice**
  **F-75008 Paris (FR)**
* **Cordier, Christophe**
  **F-75008 Paris (FR)**

(74) Mandataire: **Lottin, Claudine et al**
**Société Civile S.P.I.D.**
**156, Boulevard Haussmann**
**75008 Paris (FR)**

(56) Documents cités:
* **1991 IEEE MTT-S INTERNATIONAL MICROWAVE SYMPOSIUM DIGEST, vol.III, June 1991, BOSTON , MASSACHUSETTS pages 933 - 936, XP260320 G. HEGAZI ET AL 'A W-BAND DOUBLER/AMPLIFIER CHAIN USING A MMIC VARACTOR DOUBLER AND A MMIC POWER MESFET AMPLIFIER'**
* **IEEE TRANSACTIONS ON MICROWAVE THEORY AND TECHNIQUES, vol.40, no.3, March 1992, NEW YORK US pages 417 - 428, XP263453 H. WANG ET AL 'HIGH-PERFORMANCE W-BAND MONOLITHIC PSEUDOMORPHIC InGaAs HEMT LNA'S AND DESIGN/ANALYSIS METHODOLOGY'**
* **IEEE TRANSACTIONS ON MICROWAVE THEORY AND TECHNIQUES, vol.40, no.1, January 1992, NEW YORK US pages 12 - 28, XP244294 V. RIZZOLI ET AL 'STATE-OF-THE-ART HARMONIC-BALANCE SIMULATION OF FORCED NONLINEAR MICROWAVE CIRCUITS BY THE PIECEWISE TECHNIQUE'**

**Description**

L'invention défini dans les revendications concerne un dispositif semiconducteur incluant un circuit intégré hyperfréquences avec au moins un étage à transistor qui comprend :

un circuit d'adaptation en hyperfréquences et un circuit de polarisation en continu connectés entre eux à un noeud de liaison,

et des moyens de stabilisation incluant une ligne ouverte connectée à ce noeud de liaison, ladite ligne ouverte formant une ligne quart d'onde à la fréquence de travail à l'étage à transistor qui impose un court-circuit à la masse audit noeud de liaison à ladite fréquence de travail.

L'invention trouve son application dans tout circuit hyperfréquences large bande, par exemple pour les applications dans le domaine des télécommunications ou des circuits embarqués.

Un dispositif tel que décrit plus haut est déjà connu d'une publication intitulée « High-Performance W-Band Monolithic Pseudomorphic InGaAs HEMT LNA'S and Design/Analysis Methodology » par Huei WANG et alii, dans IEEE transactions on Microwave Theory and Techniques, VOL.40, n°3, MARCH 1992, pp.417-428. Ce document décrit un étage à transistor qui comprend sur la grille et le drain respectivement un circuit d'adaptation en hyperfréquences formé de lignes hyperfréquences et un circuit de polarisation en continu ayant au moins une résistance de polarisation de grille, dans lequel le circuit d'adaptation et le circuit de polarisation ont un noeud de connection. A ce noeud est connecté en outre une ligne ouverte pour former des moyens de stabilisation à la fréquence de travail RF. Les moyens de stabilisation comportent en outre une résistance de 50 Ω dans les moyens de stabilisation appliqués sur la grille et de 150Ω dans les moyens de stabilisation appliqués sur le drain qui, couplés à la résistance de polarisation, constituent un circuit d'amortissement aux basses fréquences.

Un autre dispositif d'un type décrit plus haut est déjà connu d'une publication intitulée «A W-Band Doubler/Amplifier Chain using a MMIC Varactor Doubler and a MMIC power MESFET Amplifier » par G. HEGAZI et alii, dans 1991 IEEE MTT-S International Microwave Symposium Digest, Vol.3, JUNE 10-14, 1991, HYNES convention Center, Boston, Massachusetts, pp. 933-936. Ce document décrit un étage à transistor qui comprend sur la grille et le drain respectivement un circuit d'adaptation formé de lignes hyperfréquences et un circuit de polarisation en continu ayant au moins une résistance de polarisation de grille, dans lequel le circuit d'adaptation et le circuit de polarisation ont un noeud de connection.

A ce noeud est connecté en outre un filtre R-C pour stabiliser le circuit dans une bande de fréquences de travail.

Un dispositif d'un type décrit dans le préambule est déjà connu du brevet JP-3-192801-A du 21-12-1989, (MITSUBISHI ELECTRIC CORP., Appl. No 1333616, publié le 22-08-1991). Ce dispositif comprend un étage hyperfréquences à transistor (1) ayant une entrée hyperfréquences (4), une sortie (2) sur le drain du transistor dont la source est à la masse, un circuit d'adaptation en hyperfréquences formé des lignes de transmission (3) et (5) appliqué sur la grille du transistor (1), et un circuit de polarisation en continu (6) connecté au circuit d'adaptation (3, 5) au noeud (13), à l'extrémité de la ligne (5). Le circuit de polarisation en continu comporte d'abord une résistance de polarisation (9) disposée entre le noeud de liaison (13) et l'alimentation continue (11) et une capacité (10) de découplage de cette alimentation continue.

Le circuit de polarisation (6) divulgué par le document JP cité comprend en outre une ligne ouverte (19) appliquée au noeud de liaison (13), qui est prévue pour former une capacité de petite valeur, capable de constituer, avec la résistance (9) de polarisation, un filtre R-C, qui prend également en compte la valeur de la capacité (10) de découplage de la tension continue (11).

Donc, dans le circuit divulgué par ce document cité, la résistance (19) de polarisation est toujours à prendre en compte dans le fonctionnement hyperfréquences. Dans ce domaine de fréquences, elle coopère avec les capacités (19, 10) pour former un filtre.

Tel que divulgué dans le document JP cité, le coefficient de réflexion, à la fréquence de travail, lorsque le circuit de polarisation (6) est considéré à partir du noeud de liaison (13), est obtenu proche de 1. Ainsi l'éventualité d'apparition d'oscillations est diminuée.

Cependant, ce circuit connu présente des inconvénients. Tout d'abord, l'obtention d'un coefficient de réflexion proche de 1, mais néanmoins légèrement négatif, n'est pas un résultat satisfaisant. Tant qu'un circuit présente un coefficient de réflexion négatif, l'éventualité d'apparition d'oscillations pernicieuses n'est pas négligeable.

D'autre part, l'élément de ligne ouverte (19) utilisé fournit un filtre centré sur une bande étroite. En dehors de cette bande, à des fréquences inférieures ou supérieures, des oscillations gênantes sont à prévoir.

Un but de la présente invention est de fournir un circuit tel que décrit dans le préambule de la revendication 1, qui est muni de moyens pour le rendre inconditionnellement stable.

Un autre but de l'invention est de fournir un tel circuit dont les moyens de stabilisation le rendent inconditionnellement stable sur une très large bande de fréquences.

Ces buts sont atteints au moyen du dispositif décrit dans le préambule de la revendication 1 et caractérisé en ce que, lesdits moyens de stabilisation incluent un circuit de stabilisation comprenant une résistance de faible valeur connectée à la masse en mode hyperfréquences à travers une capacité d'isolation en continu et connectée audit noeud de liaison,

et caractérisé en ce que à la fréquence de travail, le circuit de polarisation en continu et le circuit de stabilisation sont effectivement isolés de l'étage à transistor par le moyen du court-circuit à la masse imposé par ladite ligne ouverte et en ce que, à des fréquences autres que la fréquence de travail, le circuit de stabilisation est effectivement couplé à l'étage à transistor pour court-circuiter en pratique ledit noeud de liaison à la masse et prévenir toute oscillation.

Par ces moyens de stabilisation appliqué au circuit hyperfréquences, on obtient la présence d'un court-circuit au noeud de liaison entre le circuit de polarisation et le circuit d'adaptation : il en résulte l'avantage que le circuit de polarisation n'intervient plus dans le fonctionnement hyperfréquences sur toute la bande de la ligne ouverte quart-d'onde (en anglais $\lambda/4$ short line). De même, dans ce domaine de longueur d'onde, la résistance du circuit de stabilisation n'est absolument pas à prendre en compte.

Par contre, dès que l'on sort de la bande de fréquences où la ligne ouverte quart-d'onde impose un court-circuit au noeud de liaison A, et où des instabilités sont à craindre, alors la résistance du circuit de stabilisation produit l'amortissement des éventuelles oscillations.

Dans une mise en oeuvre, la ligne ouverte quart-d'onde est de type radial (en anglais $\lambda/4$ radial $_{stub}$).

Il en résulte l'avantage que l'action court-circuit de cette ligne quart-d'onde est large bande.

Les avantages obtenus au moyen du circuit selon l'invention résident dans le fait qu'il présente un coefficient de stabilité, considéré au noeud de liaison A vers le circuit de polarisation, toujours supérieur à 1, et donc dans le fait qu'il est inconditionnellement stable. De plus, ces avantages sont obtenus sur une large bande passante. Ainsi les pics de résonance, tant aux fréquences proches, qu'aux fréquences inférieures ou très supérieures à la fréquence de travail, sont évités.

L'invention est décrite ci-après en détail en référence avec les figures schématiques annexées dont :

- la FIG.1A représente un étage hyperfréquences à transistor muni d'un circuit d'adaptation, d'un circuit de polarisation, et des moyens de stabilisation de l'invention,
- la FIG.1B représente une ligne ouverte quart-d'onde de type radial,
- la FIG.1C représente une ligne ouverte quart-d'onde à simple ruban,
- la FIG.2A montre des courbes représentatives du coefficient de stabilité k en trait plein (courbe A) et du paramètre de stabilité I$\Delta$I en trait discontinu (courbe B) d'un circuit non muni du circuit R2, C2 de stabilisation, en fonction de la fréquence en GHz,

- la figure 2B montre par comparaison, une courbe représentative du coefficient de stabilité k en trait plein (courbe C) et I$\Delta$I en trait discontinu (courbe D) d'un tel circuit, avec le circuit R2, C2 de stabilisation selon l'invention.

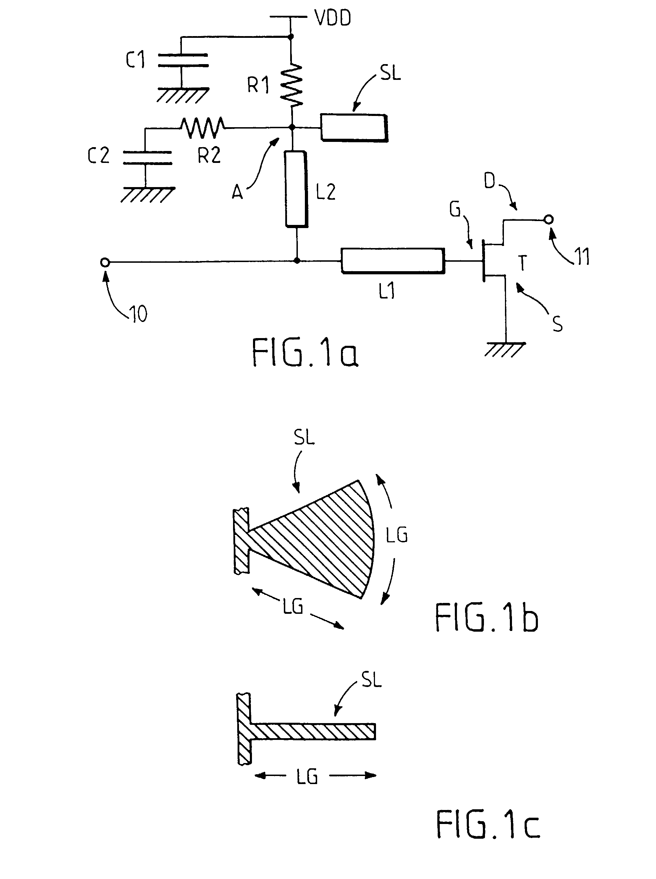

Tel que représenté sur la FIG.1A, un étage à transistor, pour être intégré dans un dispositif semiconducteur, comprend :

- un circuit d'adaptation,
- un circuit de polarisation,
- et des moyens de stabilisation.

L'étage à transistor comprend par exemple un transistor T avec une grille G, un drain D, une source S. L'entrée pour un signal hyperfréquence se fait au noeud 10 vers la grille G, et la sortie se fait au noeud 11 sur le drain D. La source S est portée à la masse.

Le circuit d'adaptation du transistor T comprend une ligne de transmission L1 disposée entre le noeud d'entrée 10 et la grille G du transistor, et une ligne de transmission L2 dont une extrémité est reliée au noeud 10 d'entrée. La seconde extrémité de la ligne de transmission L2 de ce circuit d'adaptation est le noeud de liaison A avec le circuit de polarisation du transistor T.

Le circuit de polarisation du transistor T comprend une résistance R1 disposée entre le noeud de liaison A et une alimentation continue VDD. Cette alimentation continue est en outre découplée par rapport à la masse au moyen d'une capacité C1.

Selon l'invention, au noeud de liaison A entre le circuit d'adaptation L1, L2, et le circuit de polarisation R1, C1, on impose en hyperfréquences un court-circuit au moyen d'une ligne ouverte SL quart-d'onde à la fréquence de travail.

En référence avec la figure 1B, une telle ligne ouverte SL est de type radiale et est formée par une métallisation en forme de secteur circulaire dont le centre est positionné au noeud de liaison A dont la longueur LG de l'arc périphérique est égale à $\lambda_G/4$, où $\lambda_G$ représente la longueur d'onde guidée correspondant à la fréquence de travail, et dont le rayon est aussi LG égal à $\lambda_G/4$. La ligne ouverte radiale SL peut être réalisée au gré de l'homme du métier en technologie microruban ou en technologie coplanaire. En technologie microruban, le conducteur est réalisé sur une face d'un substrat, un plan de masse est réalisé sur la face opposée et la propagation prend en compte, outre la structure du conducteur et ses dimensions, l'épaisseur du substrat et ses paramètres caractéristiques. En technologie coplanaire, le conducteur hyperfréquence et le plan de masse sont réalisés sur la même face du substrat. La propagation prend en compte, outre la structure et les dimensions du conducteur, la distance entre les bords du conducteur et le plan de masse, ainsi que les paramètres caractéristiques du substrat.

En référence avec la FIG.1C, la ligne ouverte quart-d'onde SL peut être un simple ruban de longueur LG, ouvert à son extrémité. La différence est qu'une telle ligne quart-d'onde ouverte simple n'est pas large bande comme l'est au contraire la ligne radiale.

Le circuit selon l'invention comprend en outre un circuit de stabilisation formé d'une résistance R2 de faible valeur, par exemple quelques $\Omega$. Parmi ces faibles valeurs, l'homme du métier peut choisir une résistance d'environ 5 $\Omega$. Cette résistance relie le noeud de liaison A à la masse en hyperfréquences dans certaines conditions.

Dans le domaine de fréquences où la ligne ouverte radiale $\lambda_G/4$, référencée SL, impose un court-circuit au noeud de liaison A, l'étage à transistor ne voit pas du tout la résistance R1 de polarisation, et ne voit pas non plus la résistance R2 de stabilisation.

Par contre, en dehors de ce domaine de fréquences, aux fréquences plus basses, et surtout aux fréquences plus élevées, où des oscillations sont à craindre, alors la résistance R2 de stabilisation devient efficace et amortit ces oscillations.

Dans la pratique la résistance R2 est portée à la masse à travers une capacité d'isolation en continu C2.

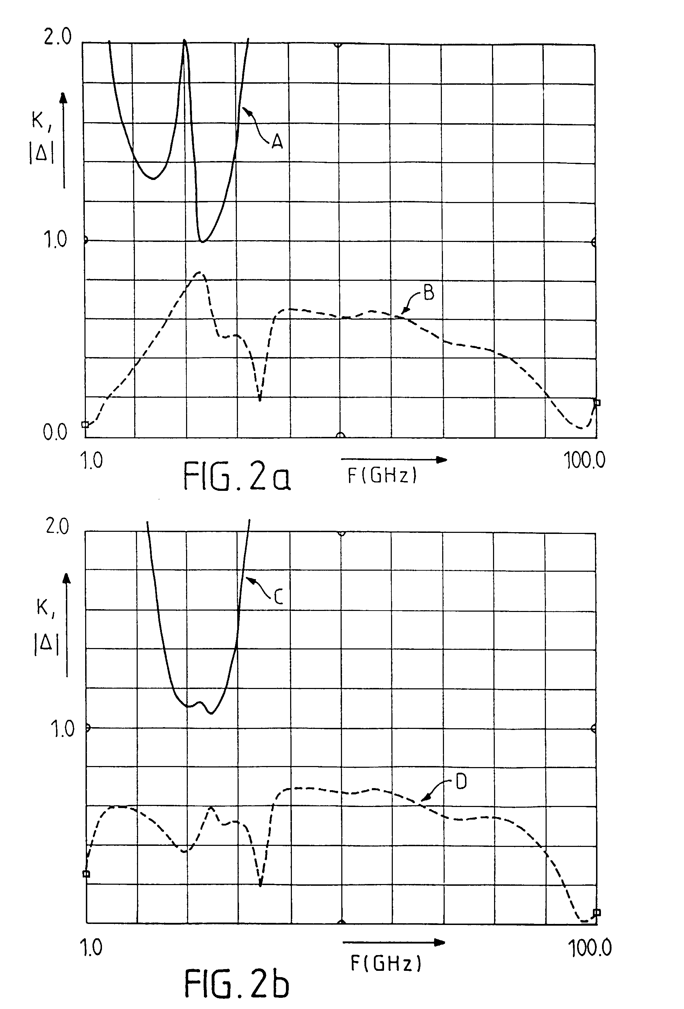

En référence avec la FIG.2A, qui montre en trait plein, sur la courbe A, le facteur de stabilité k pour un dispositif tel que celui de la figure 1A, muni du court-circuit SL formé par une ligne ouverte radiale, mais non muni du circuit de stabilisation R2, C2, il apparaît que ce facteur k passe en dessous de la valeur critique "1" pour une fréquence de travail F de l'ordre de 25 GHz.

En référence avec cette FIG.2A qui montre en trait discontinu, sur la courbe B, un autre paramètre caractérisant la stabilité, défini par :

$$|\Delta| = |(S11.S22) - (S12.S21)|$$

pour un dispositif identique non muni du circuit de stabilisation R2, C2, il apparaît un pic caractéristique d'une résonance pour cette fréquence de travail F de 25 GHz.

En référence avec la FIG.2B qui montre en trait plein, sur la courbe C, le facteur de stabilité k pour un dispositif tel que celui de la FIG.1A, à la fois muni d'un court-circuit SL formé par une ligne ouverte radiale et du circuit de stabilisation R2, C2, il apparaît que ce facteur k reste toujours très au-dessus de la valeur critique "1", et que le circuit est inconditionnellement stable dans le domaine de fréquence de travail F compris entre 1 et 100 GHz.

En référence avec la FIG.2B qui montre en trait discontinu, sur la courbe D, le paramètre $|\Delta|$, il apparaît que grâce au circuit de polarisation R2, C2 il n'existe plus de pic de résonance néfaste dans le domaine de fréquences de travail F entre 1 et 100 GHz.

Comme il est connu de l'homme du métier la relation qui lie le facteur de stabilité k et le paramètre de stabilité $|\Delta|$ est :

$$k = \frac{1+|\Delta|^2 - |S11|^2 - |S22|^2}{2.|S12|.|S21|} \quad 1$$

## Revendications

1. Dispositif semiconducteur incluant un circuit intégré hyperfréquences avec au moins un étage à transistor (T) qui comprend :

   un circuit d'adaptation en hyperfréquences (L1, L2) et un circuit de polarisation en continu (R1, C1) connectés entre eux à un noeud de liaison (A),
   et des moyens de stabilisation incluant une ligne ouverte (SL) connectée à ce noeud de liaison (A), ladite ligne ouverte (SL) formant une ligne quart d'onde ($\lambda/4$) à la fréquence de travail à l'étage à transistor (T) qui impose un court-circuit à la masse audit noeud de liaison (A) à ladite fréquence de travail,

   caractérisé en ce que lesdits moyens de stabilisation incluent un circuit de stabilisation comprenant une résistance de faible valeur (R2) connectée à la masse en mode hyperfréquences à travers une capacité (C2) d'isolation en continu et connectée audit noeud de liaison (A),
   et caractérisé en ce que à la fréquence de travail, le circuit de polarisation en continu (R1, C1) et le circuit de stabilisation (R2, C2) sont effectivement isolés de l'étage à transistor (T) par le moyen du court-circuit à la masse imposé par ladite ligne ouverte (SL) et en ce que, à des fréquences autres que la fréquence de travail, le circuit de stabilisation (R2) est effectivement couplé à l'étage à transistor (T) pour court-circuiter en pratique ledit noeud de liaison (A) à la masse et prévenir toutes oscillations.

2. Dispositif selon la revendication 1, caractérisé en ce que, la ligne ouverte quart-d'onde est de type radial.

3. Dispositif selon l'une des revendications 1 ou 2, caractérisé en ce que la résistance de faible valeur est de l'ordre de ou inférieure à 5$\Omega$.

## Patentansprüche

1. Halbleiteranordnung mit einer integrierten Hyperfrequenzschaltung mit mindestens einer Transistorstufe (T), die enthält:

   eine Hyperfrequenz-Anpassungsschaltung (L1, L2) und eine Gleichstrom-Polarisationsschaltung (R1, C1), über einen Verbindungsknoten (A) zusammengeschaltet, und Stabilisationsmittel mit einer offenen Leitung (SL), an diesen Verbindungsknoten (A) angeschlossen, während die besagte offene Leitung (SL) eine Viertel-Wellen-Leitung (λ/4) bildet, zu der Arbeitsfrequenz der Transistorstufe (T), die einen Kurzschluß bei der Masse des besagten Verbindungsknoten (A) bei der besagten Arbeitsfrequenz erzwingt,

dadurch gekennzeichnet, daß die besagten Stabilisationsmittel eine Stabilisationsschaltung enthalten mit einem Widerstand geringen Wertes (R2), an die Masse in Hyperfrequenzmodus über eine Isolationskapazität (C2) in Gleichstrom und an den besagten Verbindungsknoten (A) angeschlossen, und dadurch gekennzeichnet, daß bei der Arbeitsfrequenz die Gleichstrom-Polarisationsschaltung (R1, C1) und die Stabilisationsschaltung (R2, C2) effektiv von der Transistorstufe (T) isoliert sind, mittels eines Kurzschlusses, an der Masse über die besagte offene Leitung (SL) erzwungen, und dadurch daß bei anderen Frequenzen als bei der Arbeitsfrequenz die Stabilisationsschaltung (R2) effektiv an die Transistorstufe (T) gekoppelt ist, um in der Praxis den besagten Verbindungsknoten (A) mit der Masse kurzzuschließen und sämtlichen Oszillationen zuvorzukommen.

2. Anordnung nach Anspruch 1, dadurch gekennzeichnet, daß die offene Viertel-Wellen-Leitung radialen Typs ist.

3. Anordnung nach einem der Ansprüche 1 oder 2, dadurch gekennzeichnet, daß der Widerstand geringen Wertes eine Größe von 5Ω oder weniger hat.

**Claims**

1. A semiconductor device including a microwave integrated circuit with at least a transistor stage which comprises:

   a microwave matching circuit (L1, L2) and a d. c. bias circuit (R1, C1) interconnected at a link node A, and
   and stabilizing means which include an open stub (SL) connected to this link node (A), said open stub (SL) forming a (λ/4) stub having the nominal frequency to the transistor stage (T) that imposes a short-circuit to ground on said link node (A) at said nominal frequency,

   characterized in that said stabilizing means include a stabilizing circuit comprising a small resistor (R2) connected to ground in the microwave mode across a d.c. isolating capacitor (C2) and connected to said link node (A),
   and characterized in that at the nominal frequency, the d.c. bias circuit (R1, C1) and the stabilizing circuit (R2, C2) are effectively isolated from the transistor stage (T) by means of the short-circuit to ground imposed by said open stub (SL) and in that, at frequencies different from the nominal frequency, the stabilizing circuit (R2) is effectively coupled to the transistor stage (T) for short-circuiting in practice said link node (A) to ground and preventing any oscillation.

2. A device as claimed in Claim 1, characterized in that the λ/4 open stub is a radial stub.

3. A device as claimed in Claim 1 or 2, characterized in that the small resistor has a value of the order of or less than 5Ω.

VDD

C1

R1

SL

C2   R2

A   L2

10

L1

D

G

11

T

S

FIG.1a

SL

LG

LG

FIG.1b

SL

LG

FIG.1c

FIG.2a

FIG.2b